# EUROPEAN PATENT APPLICATION

(11) **EP 2 361 886 A1**
(43) Date of publication of application: **31.08.2011**
(21) Application number: 10305189.2
(22) Date of filing: 25.02.2010
(51) Int. Cl.: C01G 9/00, C01G 9/02, C09C 1/04

(54) **Thermoelectric materials, their preparation and thermoelectric devices comprising them**

(71) Applicant: Corning Incorporated, Corning NY 14831 (US)
(72) Inventor: Marudhachalam, Panneerselvam, 77870 Vulaines Sur Seine (FR); Guzman, Guillaume, 77250 Veneux-Les Sablons (FR)
(74) Representative: Le Roux, Martine

(57) **Abstract**

The present invention relates to:
- a material containing Ge-doped ZnO as an n-type thermoelectric material,
- a process for the preparation of said thermoelectric material, and
- a thermoelectric device comprising said material in its n-type part.

## Description

The present invention relates to n-type thermoelectric materials as well as to thermoelectric devices comprising such materials. Said materials - bulk materials - are high temperature thermoelectrically active ZnO based oxide materials that exhibit high thermoelectric conversion. In addition, materials of the present invention are environmentally green and stable in oxidizing environment at temperatures more than 1000 °C, which is a concern for the materials that are being used currently.

### BACKGROUND OF THE INVENTION

Quest for energy generation and storage is ever increasing because of the limited resources available through fossil fuel. As a part of energy economy and CO₂ emission control, nowadays huge efforts are being made to efficiently use the available energy resources and identify potential alternate and sustainable energy sources. Among large number of efforts in this context is the recovery of waste heat from any heat generating processes. There is a huge potential to use the waste heat from power plants, incinerators, automobiles and from different industrial processes. Thermoelectric materials belong to a class of materials that convert heat energy to electrical energy based on Seebeck effect. Using an efficient thermoelectric material it is possible to make maximum use of the waste heat to convert it into useful electricity.

Basic thermoelectric energy conversion unit consists of two different active materials namely n-type and p-type semiconductors wherein electrons and holes are the dominant charge carriers respectively.

Efficiency of a thermoelectric material is determined by the thermoelectric figure of merit ZT = T(S².σ)/κ, in which S is Seebeck coefficient, σ is electrical conductivity and κ is thermal conductivity [(S².σ) being the powerfactor, T the temperature]. It is desirable to have this value as high as possible. However, there is a huge challenge associated with improving the ZT because of the interdependent parameters that govern ZT.

The materials with highest ZT reported to date are thin-film superlattices and quantum-dot superlattices. Thin film thermoelectric materials, however, are not suitable for high temperature applications such as in power plants, incinerators, automobiles and from different industrial processes.

Bulk thermoelectric materials could fit the need for high temperature applications mentioned above. Semiconductors can present higher thermoelectric properties compared to metals. The development and potential of bulk materials for thermoelectric applications is an active area of research. High-temperature bulk materials such as skutterudites, clathrates, half-Heusler alloys, and complex chalcogenides are being investigated. Fine grained bismuth-telluride material is reported to have a ZT∼1.4. These materials possess complex crystal structures and exhibit properties that are suitable for potential thermoelectric materials. However, the major concerns related to these materials are their toxicity as they contain As, Te, Sb, Se etc. Also, these materials have to be protected against oxidation in oxidizing conditions. Therefore, alternative bulk materials are needed that possess good thermoelectric conversion and in addition are environmentally green and stable in oxidizing conditions.

Considerable amount of work has been done in bulk oxide thermoelectric materials since the discovery of high ZT NaCo₂O₄ in 1997. High ZT values have also been reported for Ca₃Co₄O₉ based materials. Both types of oxide based materials belong to p-type semiconductors. As mentioned above, it is necessary to have nearly the same thermoelectric performance from n-type semiconducting material to have a module with good efficiency. n-type oxide materials such as SrTiO₃ based, LaNiO₃ based, have been studied in the literature. In₂O₃ based materials have also been investigated. ZnO based materials have also been investigated as potential candidates for high-performance n-type oxide thermoelectric materials because of high ZT value reported by Tsubota et al. for Al-doped ZnO [1]. The thermoelectric properties of undoped and doped ZnO are well studied [1-6]. ZnO is an n-type semiconducting oxide with a wide direct band gap of 3.3 eV and has the wurtzite structure where zinc ions are located at the center of a tetrahedron of oxide ions in ZnO lattice. Substitution of other cations in place of zinc would alter the band structure by the creation of new defect levels. The lattice site where substitution is made, which is a defect, also acts as a scattering center for phonons which effectively decreases the thermal conductivity of ZnO [2]. Thus by substituting zinc with other cations, it is possible to tune its electrical properties and thermal conductivity. Different dopants have been studied in the literature namely, Mg, Al, Ga, In, Pr, Nd, Eu, Sm, Nb, Ce, Ti, Mo [2,3,7-11].

Though some literature exists on Ge-doped ZnO material, as film [12] or as bulk material [13], with respect to optical properties, to the best of the inventors' knowledge, there is no literature report on thermoelectric properties of this material.

In such a context, the inventors have considered the technical problem of providing a new n-type oxide material, stable in oxidizing conditions at high temperature and with a high thermoelectric conversion powerfactor.

### THE INVENTION

In reference to the above identified technical problem, the inventors propose a new n-type bulk oxide thermoelectric material: a Ge-doped ZnO based material.

The present invention more particularly relates to a material containing Ge-doped ZnO as an n-type thermoelectric material, i.e. it relates to a new n-type thermoelectric material consisting in a material containing Ge-doped ZnO, i.e., in other words, it relates to a new use of a material containing Ge-doped ZnO as an n-type thermoelectric material.

The oxide material, proposed as new n-type thermoelectric material, is ZnO based. The thermoelectric properties of ZnO are modified by incorporation of the doping element Ge into the crystalline structure of the ZnO material by substitution or as interstitial element or by reaction with the matrix to form a secondary phase (that is dispersed in said matrix) or as non reacting oxide grain (also dispersed in the matrix). Ionic radius of Zn²⁺ in tetrahedral co-ordination is 0.6 Ǻ and that of Ge⁴⁺ is 0.39 Ǻ So for every Ge⁴⁺ substituted in place of Zn²⁺, in order to maintain charge neutrality, two free electrons are made available for conduction. Therefore, optimal substitution of Ge⁴⁺ in place of Zn²⁺ would enhance the electrical conductivity of ZnO by the introduction of new defect levels in the band structure of semiconducting ZnO.

The new thermoelectric material of the invention - material containing Ge-doped ZnO - is particularly interesting it that it presents the following advantages:
- it presents high thermoelectric properties: the addition of Ge to ZnO increases the electrical conductivity and hence the thermoelectric powerfactor of the material;
- it is resistant to oxidation at high temperatures (at temperatures more than 1 000 °C): so there is no need for encapsulation of the thermoelectric element comprising it within its structure;
- its oxide-type composition (which presents a high thermoelectric powerfactor) is able to serve as a matrix / host for a wide range of other dopants or dispersants. For example, Ce, Al, B, Zr, Ti, Ni, Sn, Fe, Ga, Mn taken individually or in combination, may be advantageously present in the composition of the material to adjust and/or improve one or another property (the given list is in no way limitative);
- it is environmentally green, it does not contain any toxic element within. So its recycling does not raise any problem;
- it is easily available and cost effective.

The material of the invention - a new n-type thermoelectric material: a material containing Ge-doped ZnO - is able to include one or more crystalline phases: Ge-doped ZnO, Zn₂GeO₄, other spinel phases depending on the dopant and unreacted starting material. Advantageously, the Ge-doped ZnO phase represents 50 - 100 % in volume.

The new n-type thermoelectric material of the invention has advantageously the following formula: Zn₁-ₓ-_{y} Geₓ Ay O, wherein A is selected from Ce, Al, B, Zr, Ti, Ni, Sn, Fe, Ga, Mn and combinations thereof; x is from 0.00001 to 0.1 and y is from 0 to 0.1.

According to a first variant, y is not 0. At least an A element is present. Such an A element may be present after a corresponding addition or(and) as an impurity. According to said variant, y is generally at least 0.00001. According to said variant, the new n-type thermoelectric material of the invention has very advantageously the following formula: Zn_{1-X-y} Geₓ A_{y} O wherein A is selected from Ce, Al, B, Zr, Ti, Ni, Sn, Fe, Ga, Mn and combinations thereof; x is from 0.00001 to 0.02 and y is from 0.00001 to 0.02.

According to a second variant, y is 0 and the new n-type thermoelectric material of the invention has the following formula: Zn₁₋ₓ GeₓO, wherein x is from 0.00001 to 0.1.

The interesting properties (see more particularly the values of the powerfactor and the small variation of said values with temperature) of the materials of the invention are shown, in a non limitative way, in the further examples.

According to its second subject-matter, the invention concerns the preparation of the thermoelectric material containing Ge-doped ZnO of the invention. The process involved is a typical powder metallurgy process, including the preparation of a mixture of powders and the heat treatment of said mixture. It is carried out with ZnO and GeO₂ powders (+ optionally at least one additional powder of another oxide, advantageously selected from the group consisting in CeO₂ A1₂O₃, B₂O₃, ZrO₂, TiO₂ NiO, SnO₂ Fe oxide(s) (Fe₂O₃, Fe₃O₄, FeO and mixtures thereof), Ga₂O₃, MnO₂ and mixtures thereof).

Within the context of the invention, the powder metallurgy process advantageously includes the following features.

The mixing step of the raw materials (at least ZnO + GeO₂ can either be carried out in a wet media or dry. In case of mixing carried out in wet media, the resulting slurry is dried in air until all the used solvent(s) is(are) evaporated. The preparation of the mixture of powders is advantageously obtained by ball milling, attrition milling, tumble mixing and combinations thereof. According to a preferred embodiment, powder mixing is carried out by attrition milling in a cubic-ZrO₂ jar and with cubic-ZrO₂ beads of size less than 1 mm in diameter. Mean particle size after the milling step is in the range of 0.001 to 30 µm.

The obtained mixture of powders is advantageously formed into a shape before or during the heat treatment (see later the possible application of a mechanical pressure). A mold is conventionally used for such a forming.

The mixed powders are treated at high temperature for reaction between the oxides (at least ZnO and GeO₂) and for sintering. The temperature range is generally of 800 - 1 400 °C. It has to be understood that the maximum temperature of the heat treatment is within that range. Said maximum temperature is preferably of (about) 1 000°C. Different heating and cooling rates can be used. The inventors have tested heating rates in the range from 25 - 300 °C/min and recommend (about) 100°C/min. The inventors have tested cooling rates in the range from 25 - 300 °C/min.

The heat treatment is advantageously carried out under Ar₂, N₂, H₂, O₂ atmosphere and combinations thereof. In such conditions, it is possible to optimise the powerfactor of the prepared material. The atmosphere should, obviously, be compatible with the exact way of carrying out the heating.

The heat treatment is advantageously carried out under vacuum at a pressure ranging from 1 Pa to 100 Pa. Under such conditions, it is so also possible to optimise the powerfactor of the prepared material.

The heat treatment is also advantageously carried out on a mechanically pressed mixture of powders. The applied mechanical pressure very advantageously lies within the range of 1 - 200 MPa. It preferably lies within the range of 40 - 100 MPa.

According to a particularly preferred variant, the heat treatment is carried out by the application of a pulsed electric current.

The variants explained above are to be considered independently and, advantageously, in any combination.

The process for the preparation of a thermoelectric material according to the invention advantageously comprises an attrition mixing and heating by the application of a pulsed electric current.

According to its third subject-matter, the invention relates to a thermoelectric device comprising an n-type part and a p-type part. Said thermoelectric device is characterized in that its n-type part comprises a thermoelectric material according to the (first subject-matter of the) invention.

The claimed invention is now illustrated, in a non limitative way, by the following examples and annexed figures.

### FIGURES

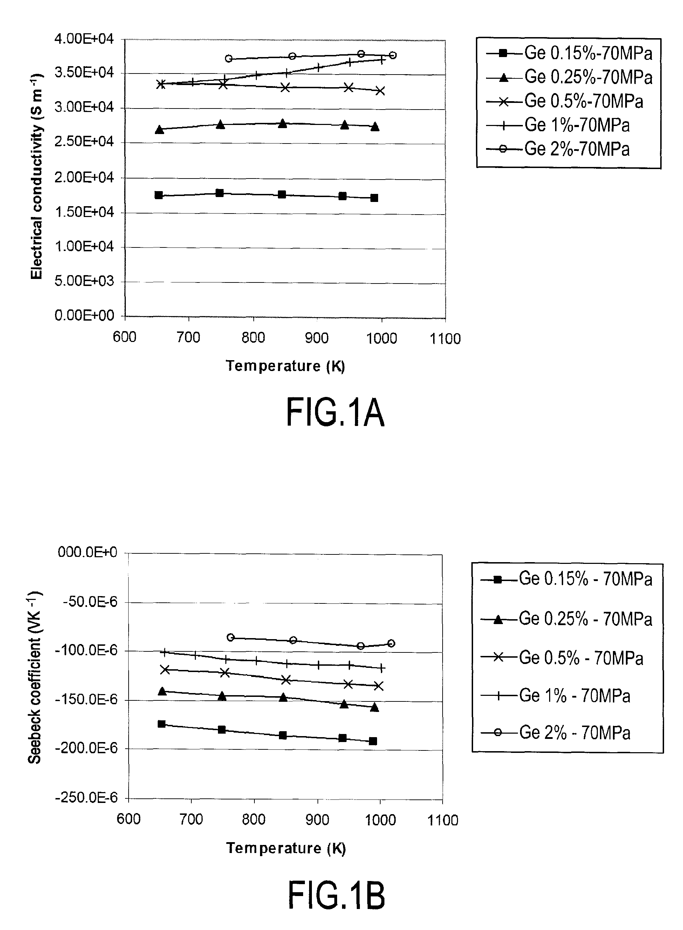

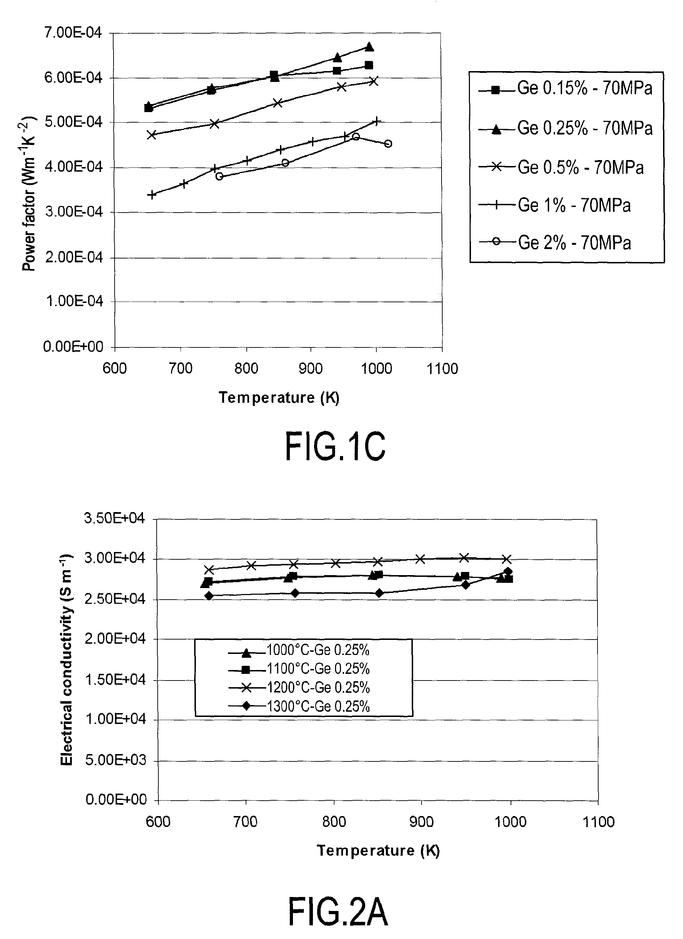

Figures 1A, 1B and 1C - Plot of the electrical conductivity (figure 1A), of the Seebeck coefficient (figure 1B) and of the resulting powerfactor (figure 1C) as a function of temperature, for thermoelectric materials of the invention showing the compositions given in the below table I, sintered under 70 MPa at a maximum temperature of 1 000°C (see below examples 1 to 5).

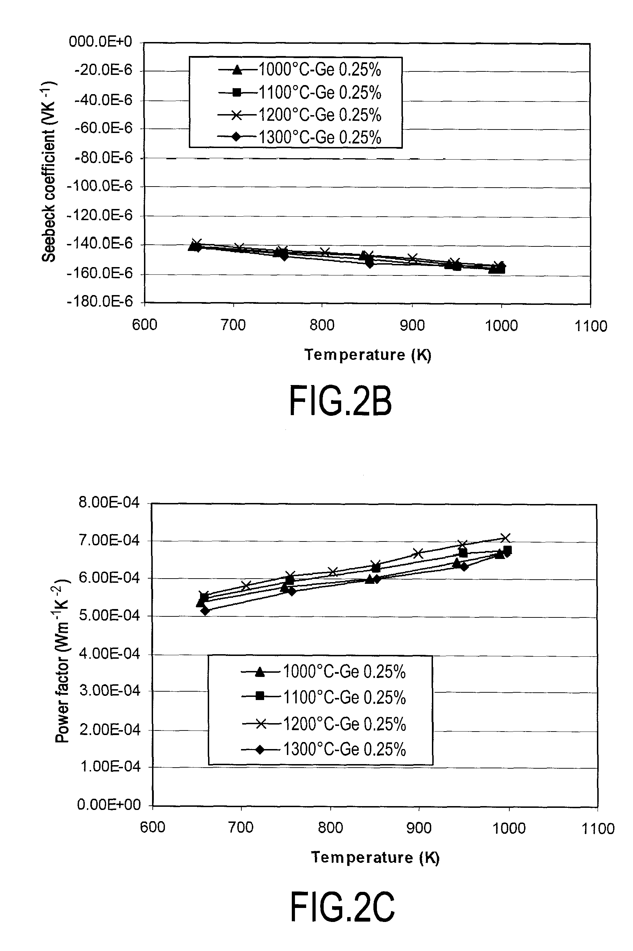

Figures 2A, 2B and 2C - Plot of the electrical conductivity (figure 2A), of the Seebeck coefficient (figure 2B) and of the resulting powerfactor (figure 2C) as a function of temperature, for thermoelectric materials of the invention showing the composition: Zn₀.₉₉₇₅ Ge₀.₀₀₂₅O, sintered under 70 MPa at different maximum temperatures (see below examples 2, 2a to 2c).

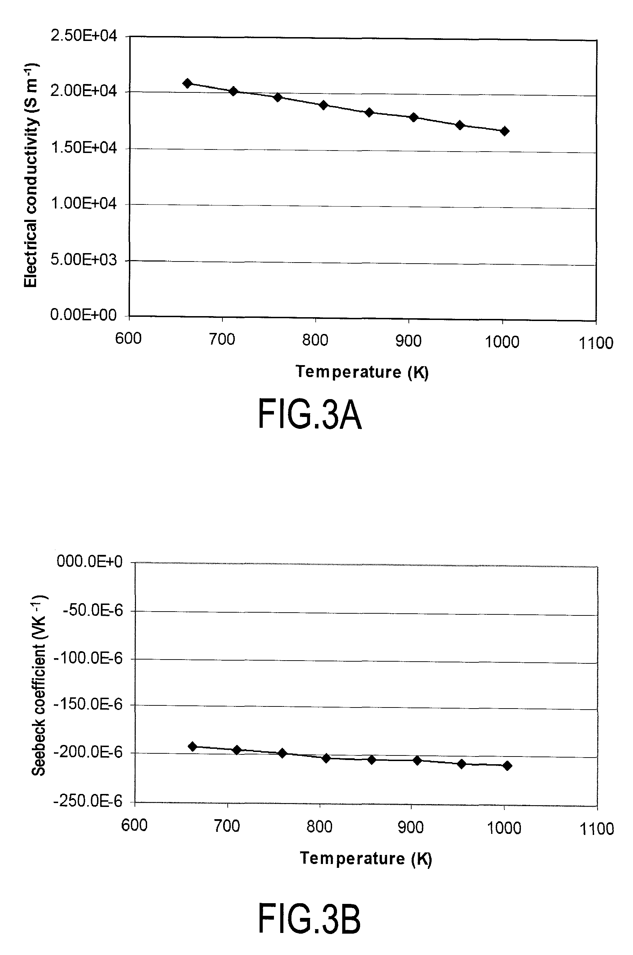

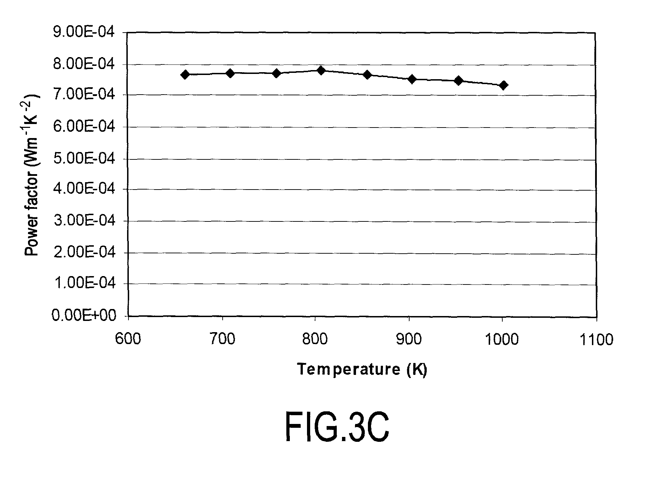

Figures 3A, 3B and 3C - Plot of the electrical conductivity (figure 3A), of the Seebeck coefficient (figure 3B) and of the resulting powerfactor (figure 3C) as a function of temperature, for thermoelectric materials of the invention showing the composition: Zn₀.₉₉₆₄₃ Ge₀.₀₀₂₅ Al₀.₀₀₀₁₈ B₀.₀₀₀₂₉ Zr₀.₀₀₀₆, sintered under 70 MPa at a maximum temperature of 1 000°C (see below example 6).

### EXAMPLES

### Examples 1 to 5

### Preparation

The preparation of thermoelectric materials according to the present invention comprises the hereafter explained successive powder preparation step and heat treatment step.

In the powder preparation step, required quantities of the component oxides (required, in reference to the formula of the aimed material) were homogeneously mixed without the presence of agglomerates of any of the individual components. This is achieved by a mixing process wherein a batch of 100 grams of the component oxides were attrition milled in a ZrO₂ container with ZrO₂ beads of 0.8 mm diameter and at a speed of 800 rpm. Ethanol was used as milling media. After milling for 6 hours, the slurry was filtered through a sieve to filter the beads. Particle size of the resulting powder mixture has a d₅₀ of 1 µm. The slurry was dried at 90°C for 24 hours in air. Such a preparation step is performed with five compositions (see Table 1 below)

Dried powders of each composition were filled in a graphite die, the inner surface of which (where the powder is filled) is covered with a graphite foil. Also graphite disks (made out of the same foil used to cover the inner surface of the graphite die) were used to cover the two surfaces (top and bottom) of the powder. This is done for good electrical contact between the powder and the pistons and also for easy removal of the pellet at the end of the process. On both graphite disks, pistons made out of solid graphite were placed. In the pistons there is a provision to measure the temperature of the sample using optical/infra-red pyrometer. The pistons & die assembly was adjusted in such a way that the powder filled in the die is positioned in the center of the die (with respect to the height). The assembly was then positioned in the centre of a spark plasma sintering unit. Spark plasma sintering (SPS) involves evacuation of the chamber, application of load to the graphite pistons and application of pulsed electric current to heat the sample at desired heating rates. Graphite die of 20 mm diameter was used for the sintering trials. Spark plasma sintering trials were carried out under vacuum (0.13 mbar). An applied pressure of 70 MPa was used. Samples were heated at 100 °C/min. Sintering was carried out at a maximum temperature of 1000 °C and held at this temperature for 5 min and cooled at 100 °C/min.

The prepared thermoelectric materials have the formulae (compositions) given in the below Table I.

### Properties of the obtained materials

Sintered samples were cut into 3 x 3 x 17 mm bars for thermoelectric characterization. Simultaneous measurement of electrical conductivity and Seebeck coefficient were made at different temperatures using the equipment ZEM-3 (M10) of the Company ULVAC-RIKO (JP).
a) Thermoelectric properties at 1000 K for the five different compositions (containing different level of Ge in ZnO) are shown in the below Table I.

**Table I**

| Examples | Composition | Ge (atom %) | Power factor (W/mK²) | Electrical conductivity (S/m) | Seebeck coefficient (µV/K) | Relative density | Thermal conductivity (W/mK) | ZT |
|---|---|---|---|---|---|---|---|---|
| 1 | Zn_{0.9985}Ge_{0.0015}O | 0.15 | 6.27E-04 | 1.74E+04 | -191 | 100.0 % | | |
| 2 | Zn₀.₉₉₇₅Ge_{0 0025}O | 0.25 | 6.69E-04 | 2.76E+04 | -156 | 99.9% | | |
| 3 | Zn₀.₉₉₅Ge₀.₀₀5O | 0.5 | 5.05E-04 | 3.28E+04 | -134 | 99.1 % | 6.16 | 0.08 |
| 4 | Zn₀.₉₉Ge0_{0.01}O | 1 | 5.92E-04 | 3.71 E+04 | -117 | 98.8 % | 6.32 | 0.09 |
| 5 | Zn₀.₉₈Ge₀.₀₂O | 2 | 4.54E-04 | 3.78E+04 | -110 | 99.2% | 5.29 | 0.08 |

b) Electrical conductivity, Seebeck coefficient and powerfactor for the five different compositions are shown in Figures 1A, 1B and 1C, respectively.

Electrical conductivity of the ZnO increases with increasing Ge content (see Figure 1A).

Negative Seebeck coefficient indicates that Ge doped ZnO is an n-type semiconductor with electrons as the major charge carriers (see Figure 1B). Seebeck coefficient decreases with increase in Ge content (see Figure 1B), which results in a decrease in powerfactor with increase in Ge content.

As mentioned before, an optimal carrier concentration is necessary to achieve best thermoelectric performance of a particular materials system. High thermoelectric conversion is found for an optimal composition of 0.25 atom% of Ge in ZnO (see Figure 1C). Worth noting aspect of the material of the current invention with optimized composition, the variation in powerfactor for a wide range of temperature is very less which is important for applications where there are temperature fluctuations.

### Examples 2. 2a, 2b and 2c

### Preparation

The preparation process described in the above examples 1 to 5 (for the same Ge content of 0.25 atom %) is carried out with different maximum temperatures of the heat treatment (of sintering):
example 2: maximum temperature of 1 000 °C
example 2a: maximum temperature of 1 100 °C
example 2b: maximum temperature of 1 200 °C
example 2c: maximum temperature of 1 300 °C.

### Properties of the obtained materials

The influence of the maximum temperature of sintering on thermoelectric properties is studied. The materials are characterized as explained in the above examples 1 to 6. The results are shown in Figures 2A to 2C. Best thermoelectric properties are observed for the sample processed at 1 200 °C. Improved thermoelectric conversion is due to increase in electrical conductivity.

### Example 6

### Preparation

The preparation process described above (for examples 1 to 5) is carried out with, in addition to 0.25 atom % Ge, the presence of other metal oxides: A1₂O₃, B₂O₃, ZrO₂ (in 0.009, 0.0145, 0.06 mol %, respectively). Said other metal oxides are added at the mixing step.

The prepared thermoelectric material has the following formula: Zno.99643 Ge_{0.0025} Al_{0.00018} B_{0.00029} Zr_{0.0006} O.

### Properties of the obtained material

The results in further improvement of thermoelectric conversion are shown in figures 3A to 3C (see more particularly figure 3C: the values of the powerfactor and the weak variation of said values with temperature).

### PRIOR ART REFERENCES

1. Tsubota, T., Ohtaki, M., Eguchi, K., Arai, H. J. Mater. Chem. 7 (1997) 85 - 90
2. M. Ohtaki, T. Tsubota, K. Eguchi, H. Arai, J. Appl. Phys. 79 (1996) 1816-1818.
3. K. Park, J.K. Seong, S. Nahm, J. Alloys and Compounds 455 (2008) 331-335.
4. H. Kaga, Y. Kinemuchi, S.Tanaka, A. Makiya, Z. Kato, K. Uematsu, K.. Watari, Jp. J. of Appl. Phys. 45 (2006) L1212-L1214.
5. Y. Inoue, Y. Okamoto, J. Morimoto, J. Mater. Sci.43 (2008) 368-377.
6. K. Fuda, S. Sugiyama, Mater. Res. Soc. Symp. Proc. 886 (2006) 473-478.
7. Y. Tanaka, T. Ifuku, K. Tsuchida, A. Kato, J. Mater. Sci. Lett. 16 (1997) 155-157
8. M.Ohtaki, K. Araki, K. Yamamoto, J. Electron. Mater. 38 (2009) 1234-1238
9. K. Park , K.Y. Ko, W.-S. Seo, W.-S. Cho, J.-G. Kim, J.Y. Kim, J. Eur. Ceram. Soc. 27 (2007) 813-817
10. K. Park, J.K. Seong, G.H. Kim, J. Alloys and Compounds 473 (2009) 423-427
11. JP-A-2007246294
12. M. Jiang, Z; Wang, Z. Ning, Thin Solid Films 517 (2009) 6717-6720
13. Y.S. Yu, G.Y. Kim, B.H. Min, S.C. Kim, J. Eur. Ceram. Soc. 24 (2004) 1865-1868

## Claims

1. A material containing Ge-doped ZnO as an n-type thermoelectric material.

2. The material according to claim 1 having one or more crystalline phases.

3. The material according to claim 1 or 2 with Ge-doped ZnO phase in the range of 50 - 100% by volume.

4. The material according to any one of claims 1 to 3 having the following general formula: Zn₁-ₓ-_{y} Geₓ A_{y} O, wherein A is selected from Ce, Al, B, Zr, Ti, Ni, Sn, Fe, Ga, Mn and combinations thereof; x is from 0.00001 to 0.1 and y is from 0 to 0.1.

5. The material according to any one of claims 1 to 4 having the following general formula Zn₁-ₓ-_{y} Geₓ Ay O wherein A is selected from Ce, Al, B, Zr Ti, Ni, Sn, Fe, Ga, Mn and combinations thereof; x is from 0.00001 to 0.02 and y is from 0.00001 to 0.02.

6. The material according to any one of claims 1 to 4 having the following general formula: Zn₁-ₓ GeₓO, wherein x is from 0.00001 to 0.1.

7. A process for the preparation of a material according to any one of claims 1 to 6, comprising the preparation of a mixture of powders and the heat treatment of said mixture, **characterized in that** said mixture comprises ZnO and GeO₂.

8. The process according to claim 7, **characterized in that** the mixture of powders is obtained by ball milling, attrition milling, tumble mixing and combinations thereof.

9. The process according to claim 7 or 8, **characterized in that** the mixture of powders is formed into a shape before or during the heat treatment.

10. The process according to any one of claims 7 to 9, **characterized in that** the mixture of powders is heat treated in the temperature range of 800 - 1400 °C.

11. The process according to any one of claims 7 to 10, **characterized in that** the mixture of powders is heat treated under Ar₂, N₂, H₂, O₂ atmosphere and combinations thereof.

12. The process according to any one of claims 7 to 11, **characterized in that** the mixture of powders is heat treated under vacuum at a pressure ranging from 1 Pa to 100 Pa.

13. The process according to any one of claims 7 to 12, **characterized in that** the mixture of powders is mechanically pressed with an applied pressure of 1- 200 MPa, while being heated.

14. The process according to any one of claims 7 to 13, **characterized in that** the heat treatment is carried out by the application of a pulsed electric current.

15. A thermoelectric device comprising an n-type part and a p-type part **characterized in that** said n-type part comprises a material according to any one of claims 1 to 6.
